# EUROPEAN PATENT APPLICATION

(11) **EP 4 838 164 A1**
(43) Date of publication of application: **11.11.2026**
(21) Application number: 25744728.4
(22) Date of filing: 24.01.2025
(51) Int. Cl.: F28D 15/04, H05K 7/20

(54) **CONDENSING DEVICE, METHOD FOR OPERATING CONDENSING DEVICE, AND HOUSEHOLD APPLIANCE**

(30) Priority: 27.01.2024 CN 202410116308
(71) Applicant: Ma, Kun, Changsha, Hunan 410114 (CN)
(72) Inventor: Ma, Kun, Changsha, Hunan 410114 (CN)
(74) Representative: Swea IP Law AB
(86) International application number: PCT/CN2025/074705
(87) International publication number: WO 2025/157265

(57) **Abstract**

The present application relates to a condensing device, comprising a condensing part, a flow guide layer, at least one flow guide member, and a flow guide channel. The flow guide layer is arranged on a condensing surface of the condensing part, and the flow guide layer and the flow guide member are each provided with a capillary structure; one end surface of the flow guide member is in contact with and connected to the flow guide layer and placed in the flow guide channel, and the flow guide channel is used for keeping the contact and connection; condensate generated on the condensing surface and the flow guide layer is continuously discharged by means of the capillary action of the flow guide layer and the flow guide member and the gravity action. In addition, the present application alsorelates to a method for operating the condensing device and a household appliance comprising the condensing device.

## Description

### TECHNICAL FIELD

The present disclosure relates to the field of liquid handling for liquid phase transition, and in particular to a condensing device. In addition, the present disclosure further relates to a method for the condensing device and a household appliance including the condensing device.

### BACKGROUND

Currently, liquid treatment and condensation treatment equipment (also referred to as liquid treatment and distillation treatment equipment) is mainly applied to industrial and laboratory environments, and purification treatment is performed on sewage by using a condensation technology (also referred to as a distillation technology). However, problems of complex structure, high manufacturing cost, and large device volume generally exist in such equipment, which limit popularization and applications thereof in household or miniaturized scenarios.

Existing sewage condensing equipment generally includes multiple modules such as an evaporator, a condenser, an air flow channel, a pump system, and a control unit. A connection between modules requires a precision process and a high standard material, which greatly increases manufacturing costs of the equipment. In addition, to ensure sufficient treatment efficiency and reliability, the equipment is often large is size and occupies relatively large space, and is difficult to adapt to application scenarios in which requirements for miniaturization and integration are relatively high. In addition, complex structures and high maintenance costs further limit equipment popularization. Especially in the direction of domestic appliance electrification, such equipment is difficult to implement a simple and user-friendly operation interface, and cannot meet requirements of small size, simple operation, and moderate price in daily household environments.

In addition, in order to release condensate from a surface of a condensation cover with the gravity action, small and simple liquid treatment condensation treatment equipment improves an effect of discharging condensate by designing a certain inclination angle. However, this inclination design also brings some technical problems that cannot be ignored: The introduction of the inclination angle of the condensation cover needs to provide enough space in the geometric design of the condensation cover to realize a proper inclination surface, which results in a significant increase in the overall volume of the condensation cover. In a compact application scenario of equipment layout, an increase in the volume of the condensation cover may occupy more mounting space, thereby limiting system feasibility. In addition, a condensation cover with an excessive volume also increases manufacturing costs and material usage of the equipment. In addition, the design of the inclination angle usually requires a certain space remaining between a condensing surface and an evaporation interface of the condensation cover. When a distance increases, vapor needs to be diffused to the condensing surface on a longer path, and interaction between vapor molecules and between the vapor and the air leads to an increase in mass transfer resistance. In addition, the vapor may be partially cooled during diffusion, so that a temperature when the vapor reaches the condensing surface is closer to a temperature of the condensing surface and a temperature difference driving force is reduced.

Document CN109292874A discloses a solar distiller for condensate collection based on capillary action. The distiller includes a condensation plate having a condensing surface and a droplet surface, and the droplet surface is in contact with an inner wall of an inner baffle of a water collection tank by means of overlapping. When hot vapor from a liquid storage tank is in contact with the condensing surface, the vapor is condensed into a liquid on the surface, and the condensed liquid is transported from the condensing surface to the droplet surface under capillary action, and a water flow or a water droplet flow is formed to the water collection tank under gravity action. However, in the solution, a length of the water collection tank needs to match a length of the droplet surface, which increases a volume, structural complexity, and manufacturing costs of equipment. In addition, the droplet surface is of a flexible structure and can only be disposed at an edge of the condensing surface, which is not conducive to production and later replacement.

Document CN113443669A discloses a distillation treatment device including a first capillary layer and a second capillary layer, where there is a gap between the two capillary layers. A first end of the first capillary layer extends into high-concentration salt water, and a second end of the first capillary layer is configured to precipitate crystalline salt. A first end of the second capillary layer is disposed below a heating part of the first capillary layer, a second end of the second capillary layer extends to a fresh water collection device, and water vapor reaches the second capillary layer through the gap to be condensed into fresh water. However, in the solution, fresh water still needs to be collected by using the fresh water collection device, and the second capillary layer is of a flexible structure, which is not conducive to production and subsequent replacement.

Document CN113247981A discloses a distiller in which a condensation cover plate of a first-stage distiller gets close to a water-absorbing wire mesh. A plurality of cotton threads above the water-absorbing wire mesh provide capillary force to draw condensed water on the cover plate into a water collection tray, so as to prevent the condensate from dripping back into a water tank of the first-stage distiller. However, in the solution, it is still necessary to collect condensate water from the water collection tray, and the used water absorbing wire mesh is used as a flexible material, which is not conducive to production and later replacement. In addition, because an interval between the cotton threads is 1-2 cm, the water-absorbing wire mesh cannot fully cover the condensing surface.

Document CN206094501U discloses a radiant panel for passive condensate removal, including a plate body, at least one heat transfer channel, and at least one dehumidification channel, where the radiant panel is made of a porous medium material. In the technical solution, a plurality of liquid guiding members are disposed on an upper part of the dehumidification channel, so as to export moisture inside the radiant panel and drive down the moisture by gravity. A condensate collection tank is provided on a lower part of the dehumidification channel, so as to collect condensate drops that fall on the conducting liquids. However, in the solution, a large quantity of liquid guiding members need to be set, which increases equipment costs. In addition, a hydrophilic coating needs to be coated on a surface of the liquid guiding member, which not only increases a surface treatment process, but also causes a service life problem of the hydrophilic coating.

As a result, complexity and high cost of existing liquid treatment condensation treatment equipment become main obstacles for popularization of the equipment. There is an urgent demand for a solution having simpler structure, lower cost, smaller size, and suitability for mass production.

### SUMMARY

An objective of the present disclosure is to provide an improved condensing device and method, so as to solve problems in the prior art that a structure is complex, costs are high, a volume is large, and production is difficult.

Therefore, according to a first aspect of the present disclosure, provided is a condensing device, including a condensing part, a flow guide layer, at least one flow guide member, and a flow guide channel, where
the flow guide layer is disposed on a condensing surface of the condensing part, and the flow guide layer and the flow guide member are each provided with a capillary structure;
one end surface of the flow guide member is connected to the flow guide layer and placed in the flow guide channel, and the flow guide channel is used for keeping the connection; and
condensate generated on the condensing surface and the flow guide layer is continuously discharged by means of the capillary action of the flow guide layer and the flow guide member and the gravity action.

In the present disclosure, by ingeniously combining the capillary structure and the gravity action, high efficiency, continuous delivery, and discharge of the condensate are implemented. The flow guide layer and the flow guide member are each provided with a capillary structure, which enables the condensate to flow rapidly in the flow guide layer by capillary force and to be effectively transferred into the flow guide member. The flow guide member is like a miniature capillary pump that continuously draws the condensate out of the flow guide layer, and the condensate is discharged in a form of droplets under the gravity action. This design effectively avoids thickening or droplet formation of a liquid film on the condensing surface, thereby maintaining stable heat resistance and ensuring continuous and efficient condensation process. Therefore, in the present disclosure, a condensation rate is significantly improved, and overall efficiency of a distillation or condensation process is improved.

By using the design of the present disclosure, the condensing surface may be horizontally disposed, which greatly shortens a distance between the condensing surface and an evaporation interface. A shorter distance means smaller heat transfer resistance, thereby further improving evaporation and condensation rates. In addition, the design of the horizontal condensing surface makes a product structure simpler and more compact, facilitates miniaturization and integration of equipment, and facilitates installation and maintenance of the equipment.

In the present disclosure, the condensate is pumped by using the capillary force of the flow guide member and is discharged in a centralized manner, so that a water collection tank commonly used in a conventional design is skillfully avoided. No water collection tank is required, which not only simplifies the structure and reduces the number of components, but also effectively reduces the volume of the equipment, so that the equipment is lighter and more compact. This is particularly important for space-limited application scenarios.

The flow guide member in the present disclosure may be quickly connected to and separated from the flow guide layer. This design greatly improves production efficiency, and is especially suitable for large-scale production. In addition, this detachable design also facilitates later maintenance and replacement, reduces maintenance costs, and prolongs the service life of the equipment.

The overall system design of the present disclosure is simple and efficient, and is applicable to miniaturized and integrated applications and large-scale applications. The design effectively improves condensation efficiency, simplifies equipment structure, reduces energy consumption and failure rate, significantly prolongs the service life of the equipment and improves economic efficiency of the equipment, and has a good application prospect.

Preferably, the flow guide layer includes at least one capillary structure of a fibrous capillary structure, a granular capillary structure, a meshed capillary structure, a layered capillary structure, a hole-shaped capillary structure, a micro groove shaped capillary structure, and a sharp corner shaped capillary structure.

Preferably, the flow guide member is made of a fiber material and still maintains structural stability after water absorption.

Preferably, the condensing device further includes a spring, and the spring is configured to ensure continuous contact between connection parts of the flow guide layer and the flow guide member.

Preferably, the condensing device further includes a container, where the flow guide channel and the flow guide member are disposed in any position inside the container.

Preferably, the condensing device further includes a capillary connector, where one end surface of the flow guide member is connected to the flow guide layer by using the capillary connector, and the capillary connector has elasticity to accommodate variations of an interval between one end surface of the flow guide member and the flow guide layer.

Preferably, the condensing device further includes a sealing member, and the sealing member is disposed between the condensing part and the container to form a first chamber configured to prevent condensate and vapor from seeping out of a gap between the condensing part and the container.

Preferably, the condensing part is of a corrugated structure.

Preferably, heat dissipation fins are disposed on a heat dissipation surface of the condensing part.

Preferably, the condensing part is of an arched structure.

Preferably, a liquid cooling channel is disposed inside the condensing part.

Preferably, the condensing device includes a plurality of containers, the plurality of containers are successively superposed vertically, a bottom surface of each container is used as a condensing surface of the condensing partof a level above, and a flow guide layer is disposed on both the condensing surface and the bottom of the container.

Preferably, the condensing device further includes a liquid inlet channel and an overflow channel, and the liquid inlet channel and the overflow channel are disposed coaxially, so that when the plurality of containers are stacked, the overflow channel of the upper container is in communication with the liquid inlet channel of the lower container.

Preferably, the condensing device further includes a fan, a heat source part, and a thermal insulation layer, the fan is configured to accelerate air flow around a surface of the condensing part, the heat source part is configured to heat a liquidtobetreated in a container, and the thermal insulation layer is disposed on an outer layer of the container, so as to reduce loss of heat inside the container to the outside.

Preferably, the flow guide layer is made of a highly thermally conductive material, the highly thermally conductive material includes a metal material having a capillary structure, such as a copper mesh or a titanium mesh, and the flow guide layer is of a single-layer or multi-layer structure.

Preferably, a drainage channel is further disposed for the flow guide layer, and the drainage channel is disposed in at least one of a linear structure, a tree-shaped structure, a meshed structure, and a meridian-shaped structure.

Preferably, the drainage channel is in contact with the flow guide layer, and one end surface of the flow guide member is connected to the drainage channel, so as to form a continuous capillary channel.

Preferably, the flow guide layer may be a nonwoven fabric made of a fiber material.

Preferably, the flow guide member may be a water-absorbing cotton strip made of a fiber material.

Preferably, a portion of the flow guide member may penetrate into the spring.

Preferably, materials of the flow guide layer and the flow guide member may be hydrophilically treated.

Preferably, the flow guide layer has a thickness of 0.01-5 mm.

Preferably, when an area of the flow guide layer is relatively large, a plurality of flow guide members and flow guide channels that match the flow guide members may be disposed at any position of the flow guide layer.

Preferably, the flow guide layer and/or the flow guide member may be made of a highly thermally conductive material, such as a copper mesh or a titanium mesh of a metal material having a capillary structure.

Preferably, one flow guide layer may be provided, or multiple flow guide layers may be stacked.

Preferably, the flow guide member and/or the flow guide member may be made of a sintered metal material, a porous metal material, metal foam, and other materials.

Preferably, the capillary connector may be made of a polymer.

Preferably, the sealing member may be of a planar structure, and one side of the sealing member may also be bonded and fixed to a condensing part or a container. The sealing member may also be a circular or rectangular cross-sectional structure, or the sealing member may be placed in a sealing member accommodation tank on a container. The condensing part and the container can be fixedly connected by screws, magnetic suction, and clamping.

Preferably, a shape of the flow guide layer matches a section of the first chamber and an upper section of the flow guide channel, and is spaced from an inner edge of the sealing member, for example, 1-5 mm.

Preferably, the heat source part may be disposed at the bottom of the container to transfer heat to the to-be-treated liquid through the bottom of the container. The heat source part may also be disposed inside the container to reduce heat transfer affected by heat resistance of a container material. The heat source part may also be disposed in the first chamber to directly heat the to-be-treated liquid. In addition, when the container is a metal material, the heat source part may further be an electromagnetic coil that heats the metal container by using an electric eddy current to heat the liquidto be treated.

Preferably, the thermal insulation layer includes at least one of polyurethane foam, polystyrene foam (EPS), a vacuum insulation panel (VIP), an aerosol felt, a rubber and plastic heat preservation material, glass fibers, perlite, and the like.

Preferably, the liquid cooling channel includes but is not limited to a straight-line flow channel, a bent flow channel, a spiral flow channel, an S-shaped flow channel, a grid flow channel, and a branch flow channel.

In addition, according to a second aspect of the present disclosure, provided is a method for operating a condensing device, where the condensing device is constructed according to the foregoing preferred design solution.

In addition, according to a third aspect of the present disclosure, provided is a household appliance, including the condensing device constructed according to the foregoing preferred design solution.

Preferably, the household appliance may be a fish tank, a cleaning robot, a floor washer, a pet water dispenser, a dishwasher, or the like.

Various design solutions in the present disclosure may be implemented alone or in any combination. In particular, without departing from the scope of the present disclosure, the foregoing and the following features to be explained may be used not only in the described combination, but also in other combinations or individually.

### BRIEF DESCRIPTION OF THE DRAWINGS

The drawings are not intended to be drawn in scale. For the sake of clarity, not every component is marked in each drawing. Embodiments of the present disclosure will now be described by way of example only with reference to the schematic drawings, in which:
FIG. 1 shows a structure diagram of a condensing device according to one embodiment of the present disclosure;
FIG. 2 shows a structure diagram of positions of a flow guide channel and a flow guide member in a container in FIG. 1;
FIG. 3 shows a structure diagram of a condensing device according to another embodiment of the present disclosure;
FIG. 4 shows a structure diagram of a condensing device according to another embodiment of the present disclosure;
FIG. 5 shows a schematic diagram of a first structure of a condensing part according to one embodiment of the present disclosure;
FIG. 6 shows a schematic diagram of a second structure of a condensing part according to another embodiment of the present disclosure;
FIG. 7 shows a schematic diagram of a third structure of a condensing part according to another embodiment of the present disclosure;
FIG. 8 shows a structure diagram of a multi-stage condensing device according to one embodiment of the present disclosure;
FIG. 9 shows a structure diagram of a condensing device according to another embodiment of the present disclosure; and
FIG. 10 shows a structure diagram of a multi-stage condensing device according to another embodiment of the present disclosure.

In each drawing, elements that have same function and function manner are respectively provided with a same reference numeral.

### DETAILED DESCRIPTION OF THE EMBODIMENTS

Aspects and embodiments disclosed herein are not limited to the details of the construction and arrangement of the elements described in the following description or illustrated in the drawings. The aspects and embodiments disclosed herein can be practiced or executed in various ways.

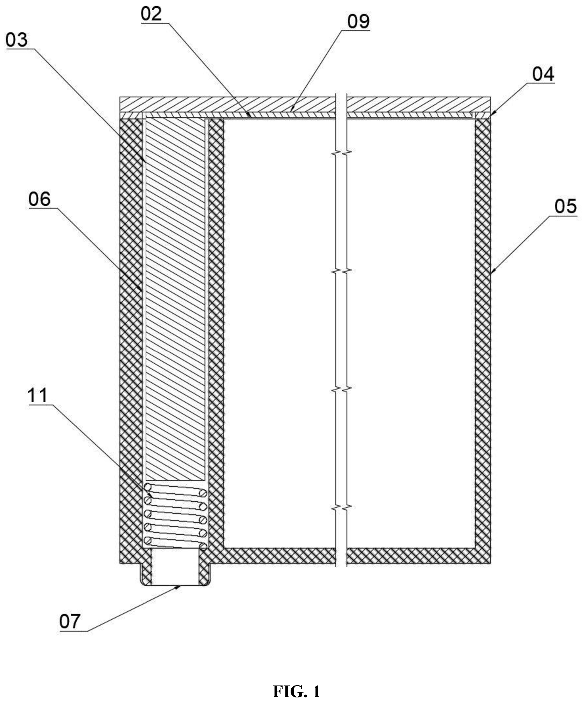

FIG. 1 shows a structure diagram of a condensing device according to one embodiment of the present disclosure. The condensing device includes a flow guide layer 02, a flow guide member 03, a spring 11, a flow guide channel 06, and a water outlet 07. The flow guide layer 02 and the flow guide member 03 are each provided with a capillary structure, and the flow guide layer 02 is in contact with and connected to the condensing surface 09.

The flow guide layer 02 includes at least one capillary structure of a fibrous capillary structure, a granular capillary structure, a meshed capillary structure, a layered capillary structure, a hole-shaped capillary structure, a micro groove shaped capillary structure, and a sharp corner shaped capillary structure. For example, the flow guide layer 02 may be a nonwoven fabric made of a fiber material.

The condensing surface 09 of the condensing part 01 is in close contact with and connected to the flow guide layer 02, for example, which is implemented in at least one of fitting, adhesion, gluing, hot melting, sintering, hot air bonding, welding and other manners.

The flow guide member 03 is made of a capillary structure material with certain mechanical strength, so as to ensure that the flow guide member 03 does not deform in a wet state and a dry state and achieve quick connection and separation between the flow guide member 03 and the flow guide layer 02. For example, when being a water-absorbing cotton strip, the flow guide member 03 is usually made of a fiber material. Reasonable fiber arrangement mode and bonding technology are adopted to ensure sufficient tensile strength and tear resistance during use. In addition, the water-absorbing cotton strip can maintain certain structural stability after water absorption, without losing load-carrying capacity or undergoing fiber separation caused by water swelling.

The flow guide member 03 is disposed in the flow guide channel 06. The flow guide channel 06 is configured to maintain sufficient contact between an upper end face of the flow guide member 03 and the flow guide layer 02, so as to ensure that the flow guide member 03 is fully connected to the capillary channel of the flow guide layer 02. The flow guide channel 06 is further configured to isolate the to-be-treated liquid, so as to form an independent and clean condensate transfer channel. One end surface of the flow guide member 03 is in contact with and connected to the flow guide layer 02, and continuous contact between connection parts of the flow guide layer 02 and the flow guide member 03 is ensured by using a spring force of the spring 11, so as to avoid manufacturing or mounting errors or hot expansion and cold shrinkage of materials or a gap generated in a disassembly process, thereby affecting rapid transfer of the condensate. Therefore, an elastic deformation capability of the spring 11 can be compensated within a certain range, so that a connection between the flow guide layer 02 and the flow guide member 03 is more adaptable.

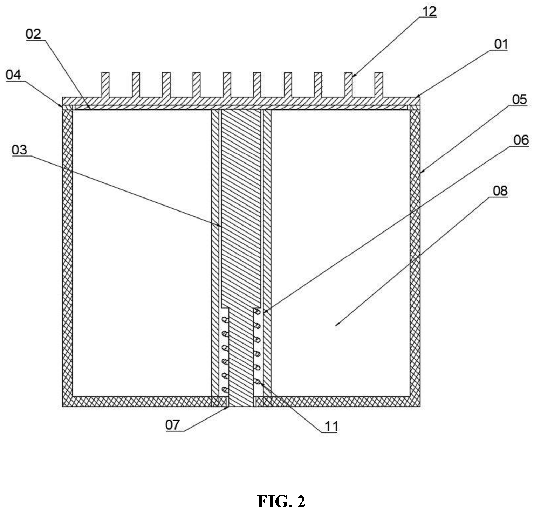

FIG. 2 shows a structure diagram of positions of a flow guide channel and a flow guide member in a container in FIG. 1. The flow guide channel 06 and the flow guide member 03 are disposed in the middle of a container 05, and a portion of the flow guide member 03 may penetrate into a spring 11, so as to select a spring with a longer stroke and softer elastic force and prevent a capillary channel of the flow guide layer 02 from being compressed due to excessive elastic force to affect capillary force. A continuous liquid transfer path is formed under the capillary action by using capillary channels that are in contact with each other. Condensate may be rapidly transferred from the flow guide layer 02 to the flow guide member 03, so as to implement efficient transfer of the condensate. In addition, materials of the flow guide layer 02 and the flow guide member 03 may be hydrophilically treated, so as to further optimize liquid transfer performance.

When the vapor generated by evaporation of the to-be-treated liquid meets the flow guide layer 02 and the condensing surface 09, the temperature of the vapor is reduced, so that the vapor is converted into liquid condensate again. Under the capillary action of the flow guide layer 02, the condensate flows to each part of the flow guide layer 02. When the condensate reaches a contact part between the flow guide layer 02 and the flow guide member 03, the condensate flows inside the flow guide member 03 under the capillary action of the flow guide member 03. Under the action of gravity, the condensate is collected at a lower part of the flow guide member 03, and droplets are formed to drip from the flow guide member 03 to a water outlet 07, so that the condensate in the flow guide layer 02 is continuously drawn by the flow guide member 03. The condensate continuously flows out from the flow guide layer 02, thereby preventing thickening or droplet formation of a liquid film on the condensing surface 09. Under continuous drawing of the flow guide member 03, a thickness of the liquid film always does not exceed a thickness of the flow guide layer 02. Therefore, heat resistance of the flow guide layer 02 does not change, that is, the heat resistance is the heat resistance of the flow guide layer 02 that includes the condensate. Therefore, stable heat resistance is achieved to maintain a sustainable condensing effect.

Because the thickness of the liquid in the flow guide layer 02 under the action of capillary force does not exceed the thickness of the flow guide layer 02, heat transfer resistance is constant. The thinner the flow guide layer 02, the smaller the heat transfer resistance is. However, the less the capillary structure of the flow guide layer 02, the lower the capillary force, and the lower the flow speed of the liquid. In actual application, the thickness of the flow guide layer 02 is 0.01-5 mm according to a manufacturing process and an application requirement, for example, 0.01 mm, 0.05 mm, 0.08 mm, 0.15 mm, 0.25 mm, 0.3 mm, 0.35 mm, 0.5 mm, 1 mm, 2 mm, 3 mm, and 5 mm.

When an area of the flow guide layer 02 is relatively large, in order to ensure rapid discharge of the condensate, a plurality of flow guide members 03 and flow guide channels 06 that match the flow guide members 03 may be disposed at any position of the flow guide layer 02.

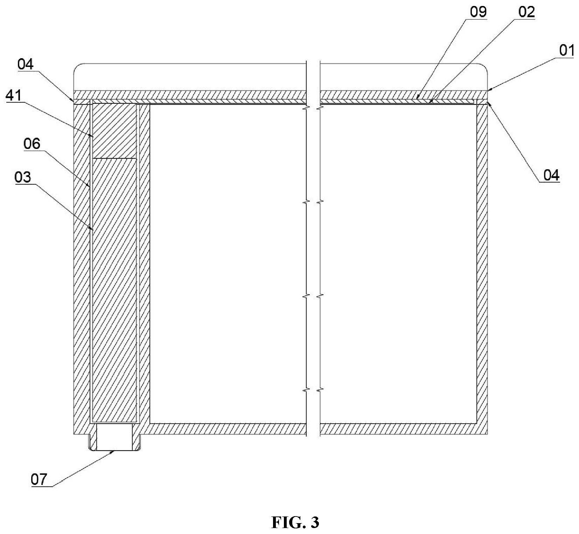

FIG. 3 shows a structure diagram of a condensing device according to another embodiment of the present disclosure. The condensing device includes a flow guide layer 02, a flow guide member 03, a capillary connector 41, a flow guide channel 06, and a water outlet 07. The flow guide layer 02 and the flow guide member 03 are each provided with a capillary structure, and the flow guide layer 02 is in contact with and connected to the condensing surface 09.

The flow guide layer 02 may be made of a highly thermally conductive material, such as a copper mesh or a titanium mesh of a metal material having a capillary structure. One flow guide layer 02 may be provided, or multiple flow guide layers may be stacked.

The flow guide member 03 is made of a capillary structure material with certain mechanical strength. For example, the flow guide member 03 may be made of a sintered metal material, a porous metal material, metal foam, and other materials, and has good capillary action and mechanical strength by means of the complex capillary structure therein.

One end surface of the flow guide member 03 is connected to the flow guide layer 02 by using the capillary connector 41. The capillary connector 41 has certain elasticity to adapt to an interval change between one end surface of the flow guide member 03 and the flow guide layer 02, so as to ensure that one end surface of the flow guide member 03 and the flow guide layer 02 are fully in contact with the capillary connector 41, to form a liquid transmission path of a continuous capillary channel. For example, the capillary connector 41 may be made of a polymer to have certain elasticity to adapt to the interval change. A continuous liquid transfer path is formed under the capillary action by using capillary channels that are in contact with each other. Condensate may be rapidly transferred from the flow guide layer 02 to the flow guide member 03, so as to implement efficient transfer of the condensate.

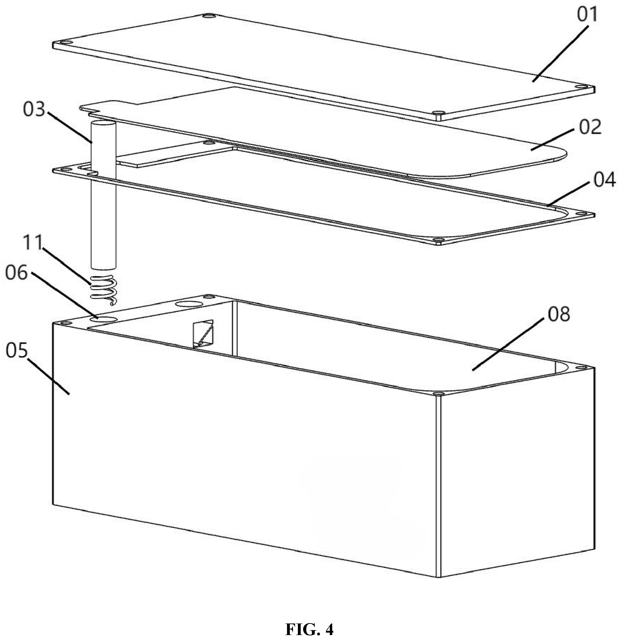

FIG. 4 shows a structure diagram of a condensing device according to another embodiment of the present disclosure. The condensing device includes a condensing part 01, a flow guide layer 02, a flow guide member 03, a sealing member 04, a container 05, a flow guide channel 06, and a water outlet 07. The condensing device is provided with the flow guide layer 02 that has a capillary structure and the flow guide member 03 on the condensing surface 09 of the condensing part 01, thereby implementing rapid discharge of the condensate, and improving stability and continuity of condensation rate and condensate collection.

The condensing surface 09 of the condensing part 01 is in close contact with and connected to the flow guide layer 02, for example, which is implemented in at least one of fitting, adhesion, gluing, hot melting, sintering, hot air bonding, welding and other manners.

To ensure continuous contact between connection parts of the flow guide layer 02 and the flow guide member 03, a spring 11 is disposed in the device, and a reliable connection between the flow guide layer and the flow guide member is maintained by using a spring force. When the condensing part 01 is connected to or separated from the container 05, the flow guide member 03 is also correspondingly connected to or separated from the capillary channel of the flow guide layer 02. This design structure is simple and reliable.

The sealing member 04 is disposed between the condensing part 01 and the container 05 to form a relatively closed first chamber 08. A main function of the sealing member 04 is to prevent the condensate from leaking out of a gap between the condensing part 01 and the container 05, so as to avoid water leakage. At the same time, vapor is prevented from escaping from the gap, so as to reduce the loss of vapor and temperature. In addition, an odor of the to-be-treated liquid can be effectively prevented from overflowing, so as to improve user experience.

The sealing member 04 may be in multiple structural forms, such as a planar structure, a circular structure, or a rectangular cross-sectional structure. In a specific implementation, one side of the sealing member 04 may be bonded and fastened to the condensing part 01 or the container 05, so as to facilitate production and later maintenance. Alternatively, the sealing member 04 may also be disposed in a sealing member accommodating groove (not shown in the figure) on the container 05.

The condensing part 01 and the container 05 may be fixedly connected by using screw, magnetic suction, snap and other manners.

A shape of the flow guide layer 02 matches a cross section of the first chamber 08 and an upper cross section of the flow guide channel 06, and maintains a distance from an inner edge of the sealing member 04, for example, 1-5 mm, to prevent the condensate in the flow guide layer 02 from coming into contact with the sealing member 04.

The to-be-treated liquid is placed in the first chamber 08. When the vapor generated by vaporization meets the flow guide layer 02 and the condensing part 01, the temperature decreases and the vapor is condensed into a liquid condensate again. Under the capillary action of the flow guide layer 02, the condensate flows to each part of the flow guide layer 02. When the condensate reaches a contact part between the flow guide layer 02 and the flow guide member 03, the condensate flows inside the flow guide member 03 under the capillary action of the flow guide member 03. Under the action of gravity, the condensate is collected at a lower part of the flow guide member 03, and droplets are formed to drip from the flow guide member 03 to the water outlet 07. By means of continuous drawing of the flow guide member 03, condensate in the flow guide layer 02 continuously flows out, thereby effectively preventing thickening or droplet formation of a liquid film on the condensing surface 09 of the condensing part 01. A thickness of the liquid film always does not exceed a thickness of the flow guide layer 02 because of a continuous drawing action of the flow guide member 03. Therefore, heat resistance between the condensing part and the flow guide layer 02 is stable, that is, the heat resistance is a sum of heat resistance of a material of the condensing part 01 and heat resistance of the flow guide layer 02 that contains the condensate, thereby ensuring a sustainable condensation effect.

Materials of the flow guide layer 02 may be various. For example, a material such as ES fiber may be used to produce a fibrous capillary structure in a hot air bonding manner. A specific connection method includes but is not limited to fitting, adhesion, gluing, hot melting, sintering, hot air bonding, welding, and the like. For example, the ES fiber may be bonded to the condensing surface 09 by means of hot fusion at a contact position by heating or preheating the material of the condensing part and/or hot air bonding, and another ES fiber and the fiber are bonded to each other to form the flow guide layer 02 having a capillary structure. Alternatively, the fiber may be directly sprayed on the material of the condensing part by using a melt-blown nonwoven process to form the flow guide layer 02 of the fibrous capillary structure. For another example, the prepared polypropylene material flow guide layer 02 is welded to a plastic plate (such as acrylic or organic glass) by means of ultrasonic spot welding or continuous welding, or fiber of a polypropylene material is directly sprayed on the plastic plate by using a melt-blown nonwoven process, to form the flow guide layer 02 of the fibrous capillary structure. When the condensing surface 09 is a metal material, the flow guide layer 02 may be connected in a point-like or line-like adhesive local adhesion manner. Alternatively, the flow guide layer 02 of a metal material may be sintered or welded to the condensing surface 09, for example, a metal mesh, a foam metal, or a metal felt. The foregoing is merely an example, and is not limitation of the present disclosure.

It may be understood that, when an area of the condensing part 01 is relatively large, to ensure rapid discharge of the condensate, a plurality of flow guide members 03 and flow guide channels 06 that match the flow guide members 03 may be disposed at any position of the flow guide layer 02.

By using the foregoing design, the condensing device provided in this embodiment shortens a distance between the condensing surface 09 and an evaporation interface, and improves evaporation and condensation rates. A problem of uneven vapor distribution is avoided, and condensation efficiency is improved. The overall system design is simple and efficient, and is suitable for both miniaturized and integrated applications and large-scale applications. In addition, the device is easy to manufacture, mount, and maintain.

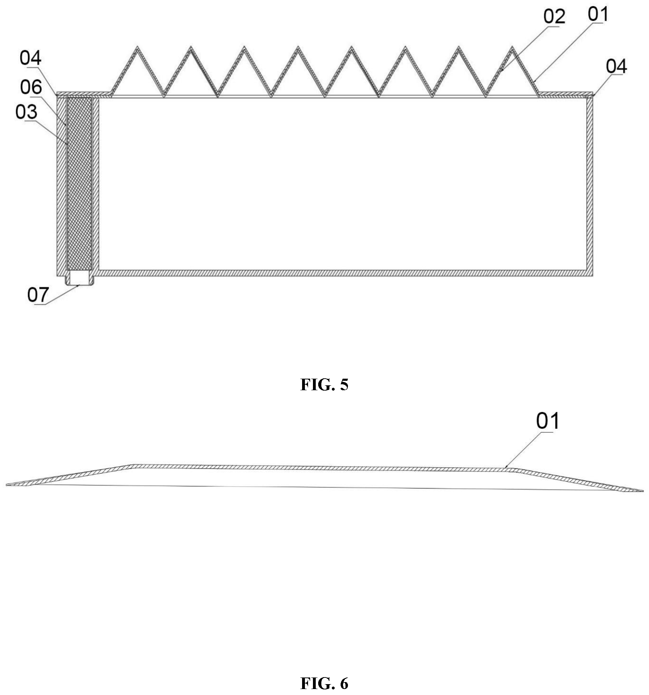

FIG. 5 shows a schematic diagram of a first structure of a condensing part according to one embodiment of the present disclosure. In the embodiment, the condensing part 01 is of a corrugated structure. The design of the corrugated structure has multiple advantages: First, the structure significantly enhances the rigidity of the material of the condensing part 01, and improves the compression resistance and bending performance in a vertical direction, so that the structure can withstand more pressure and bending force, thereby ensuring the stability and reliability of the device. Second, the corrugated structure increases surface areas of the condensing surface 09 of the condensing part 01 and a heat dissipation surface, increases the temperature difference driving force, and effectively improves the condensing efficiency. In addition, because the corrugated structure enhances the strength of the material, a thinner material may be selected to manufacture the condensing part 01, thereby reducing structural weight and meeting a lightweight design requirement. In actual production, fabrication processing such as bending or stamping may be performed on a plate that is bonded and connected to the flow guide layer 02 and that is of the condensing part 01, so as to produce the required corrugated structure.

Referring to FIG. 2 again, another structural form of the condensing part 01 is shown. In the embodiment, heat dissipation fins 12 are disposed on a heat dissipation surface of the condensing part 01. The heat dissipation fins 12 are designed to further improve heat dissipation performance of the condensing part 01. Specifically, the heat dissipation fins 12 significantly increase a heat exchange area of the condensing part 01, thereby effectively improving overall heat dissipation efficiency of the condensing part, and accelerating a condensation process. In addition, setting of the heat dissipation fins 12 also enhances overall strength and stability of the condensing part 01, and improves mechanical performance of the device.

FIG. 6 shows a schematic diagram of a second structure of a condensing part according to another embodiment of the present disclosure. In the embodiment, the condensing part 01 is of an arched structure. A main advantage of the arched structure is to improve a pressure bearing capability of the condensing part 01, so that the condensing part can withstand a higher internal pressure. For example, the condensing part 01 not only optimizes structural strength and avoids stress concentration by means of a natural transition design between an arc edge and a top microplane, but also gives a concise and smooth appearance to the condensing part 01, thereby improving overall attractive appearance of the device. In actual production, fabrication processing such as stamping may also be performed on a plate that is connected to the flow guide layer 02 and that is of the condensing part 01, so as to produce the required arched structure.

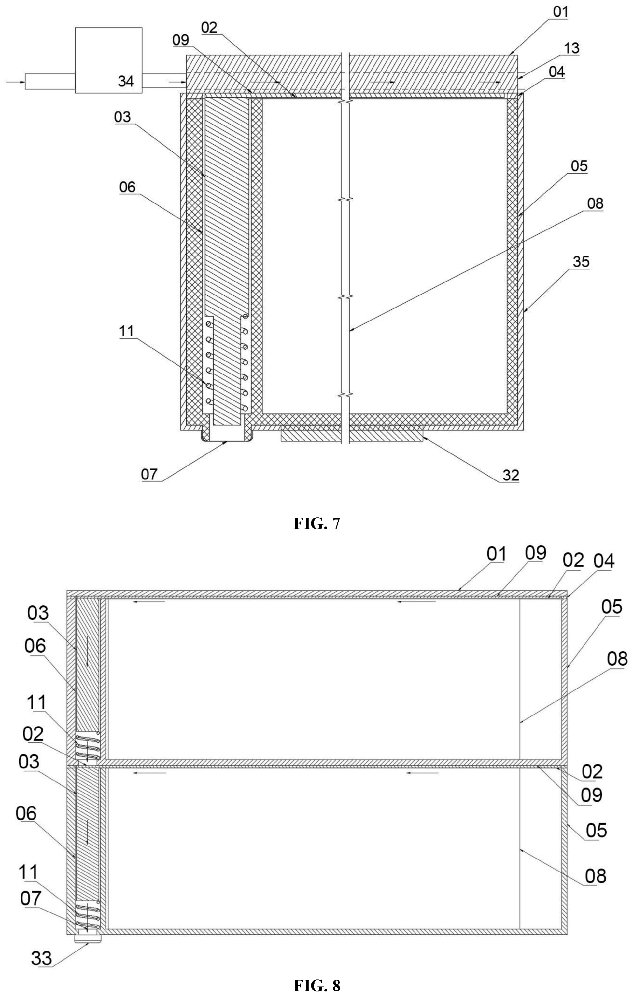

FIG. 7 shows a schematic diagram of a third structure of a condensing part according to another embodiment of the present disclosure. In the embodiment, a liquid cooling channel 13 is provided in the condensing part 01. The liquid cooling channel 13 is provided along a surface of the condensing part 01 or inside the condensing part. By means of circulation of a coolant, heat released during a condensation process can be quickly removed, and a low temperature of the condensing surface 09 can be effectively maintained, thereby significantly enhancing a condensation rate of vapor.

A form of a flow channel of the liquid cooling channel 13 may be selected according to an actual requirement, including but not limited to a straight-line flow channel, a bent flow channel, a spiral flow channel, an S-shaped flow channel, a grid flow channel, and a branch flow channel.

Compared with a manner such as natural cooling or air cooling, a liquid cooling manner has higher heat transfer efficiency, which helps to stabilize condensation performance. For example, increasing the coolant flow rate can take away heat more quickly, accelerate the condensation rate, and improve the condensation efficiency. However, reducing the flow rate can reduce the condensation rate and avoid excessive cooling or energy waste. By adjusting the coolant flow rate, the condensation rate can be accurately controlled according to an actual heat load, so as to flexibly adapt to different operating conditions. This design not only improves the adaptability of the system, but also optimizes the energy utilization efficiency. In addition, the stability and reliability of equipment operation are maintained, thus achieving good balance between efficient condensation and energy-saving operation.

FIG. 8 shows a structure diagram of a multi-stage condensing device according to one embodiment of the present disclosure. By sequentially superimposing a plurality of containers 05 vertically, the multi-stage condensing device implements multi-stage utilization of energy, and increases an evaporation surface and a condensing surface, thereby improving the evaporation rate and the condensation rate.

Specifically, a bottom surface of each container 05 is used as a condensing surface 09 of an upper condensing part 01, and a flow guide layer 02 is disposed on both the condensing surface 09 and the bottom of the container 05, so that condensate can be rapidly transferred from the flow guide layer 02 to the flow guide member 03. Latent heat released by water vapor condensation is transferred upwardly to to-be-treated liquid in the container 05 through the flow guide layer 02 and the bottom of the container 05, thereby implementing effective recovery and utilization of energy.

In the multi-stage structure, the condensate discharged from the upper flow guide member 03 flows to the lower flow guide layer 02, and is discharged through the lower flow guide member 03. By analogy, the condensate is finally discharged from a water outlet 07 of the lowest container 05. To prevent the condensate from leaking out of a gap between the upper and lower containers 05, the adjacent containers 05 are sealed and connected by using the sealing member 04, so as to ensure sealing performance and running efficiency of the device.

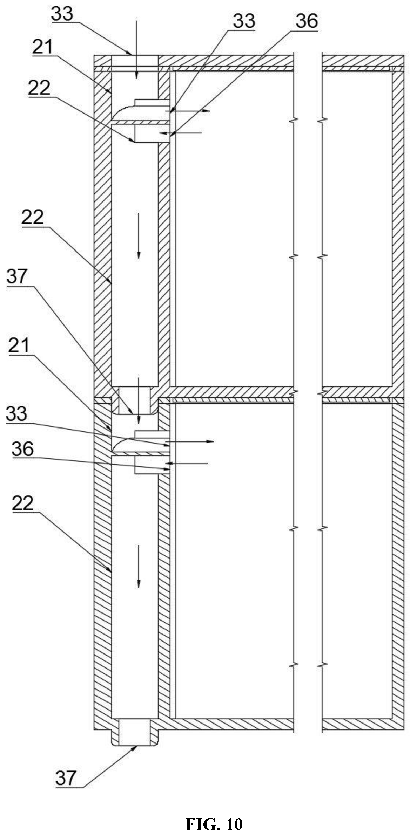

FIG. 10 shows a structure diagram of a multi-stage condensing device according to another embodiment of the present disclosure, where the multi-stage condensing device further includes a liquid inlet channel 21 and an overflow channel 22. The liquid inlet channel 21 and the overflow channel 22 are disposed coaxially, so that when a plurality of containers 05 are stacked, the overflow channel 22 of the upper container 05 is in communication with the liquid inlet channel 21 of the lower container 05.

To-be-treated liquid flows into the liquid inlet channel 21 from a liquid inlet 33, and then flows into a first chamber 08 from the liquid inlet 33. After a liquid level in the first chamber 08 reaches an overflow port 36, the to-be-treated liquid flows into the overflow channel 22 from the overflow port 36, and flows into the liquid inlet channel 21 of the next container 05 through a liquid outlet 37. In this manner, a liquid level of the to-be-treated liquid always does not exceed a height of the overflow port 36, so as to maintain a liquid level height set in each first chamber 08, thereby ensuring stable condensation process.

In actual application, to further improve the sealing effect and prevent the to-be-treated liquid from leaking between the upper and lower containers 05, when the overflow channel 22 of the upper container 05 is in communication with the liquid inlet channel 21 of the lower container 05, the liquid outlet 37 of the upper container 05 and the liquid inlet channel 21 of the lower container 05 may be sealed by using a sealing ring (not shown in the figure), so as to ensure that the to-be-treated liquid flowing out of the upper container 05 can effectively flow into the lower container 05, thereby supplementing the to-be-treated liquid for the lower container 05.

By using the foregoing multi-stage superposition structure and a liquid inlet/overflow channel design, the condensing device not only improves energy utilization efficiency, but also increases effective areas of evaporation and condensation, thereby significantly improving the evaporation rate and the condensation rate, and implementing an efficient condensation process. In addition, the design also ensures independence and stability of the condensation processes at all stages, avoids mutual interference, and improves overall performance of the device.

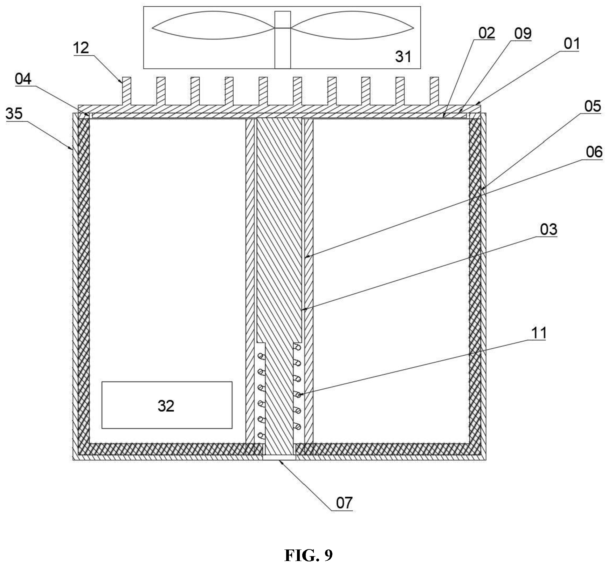

FIG. 9 shows a structure diagram of a condensing device according to another embodiment of the present disclosure. The condensing device includes a fan 31, a heat source part 32, and a thermal insulation layer 35, and a condensing part 01, a flow guide layer 02, a flow guide member 03, a sealing member 04, a container 05, a flow guide channel 06, a spring 11, and a water outlet 07 that are described in the foregoing embodiments.

The heat source part 32 is configured to heat the to-be-treated liquid in the container 05, so as to accelerate the evaporation speed, thereby improving the condensation speed, and finally accelerating the treatment speed of the to-be-treated liquid. A setting manner of the heat source part 32 may be flexibly selected according to an actual situation. For example, the heat source part may be disposed at the bottom of the container 05, and heat is transmitted to the to-be-treated liquid through the bottom of the container 05. The heat source part may alternatively be disposed inside the container 05, so as to reduce an impact of material heat resistance of the container 05 on heat transfer. The heat source part may alternatively be disposed in the first chamber 08, so as to directly heat the to-be-treated liquid. In addition, when the container 05 is a metal material, the heat source part 32 may further be an electromagnetic coil, and the metal container 05 is heated by using electric eddy current, so as to heat the to-be-treated liquid.

The to-be-treated liquid is evaporated into water vapor in the first chamber 08, and the water vapor is condensed into condensate after meeting the flow guide layer 02. The heat released during the condensation process is transferred outward through the condensing part 01. The fan 31 is configured to accelerate air flow around a surface of the condensing part 01, improve heat transfer efficiency, quickly remove heat released by the condensing part 01, and maintain a low-temperature state of the surface of the condensing part 01, so as to accelerate a condensation process of vapor. The generated condensate is discharged to the water outlet 07 through the flow guide member 03, so as to complete evaporation treatment of the to-be-treated liquid.

The thermal insulation layer 35 is disposed on an outer layer of the container 05, so as to reduce loss of heat inside the container 05 to the outside, keep a temperature in the heating container 05 stable, and improve heating efficiency, thereby saving energy. In addition, the thermal insulation layer 35 may further protect surrounding equipment and environment from being affected by a high temperature. A material of the thermal insulation layer 35 may include but not limited to at least one of polyurethane foam, polystyrene foam (EPS), a vacuum insulation panel (VIP), an aerosol felt, a rubber and plastic heat preservation material, glass fibers, perlite, and the like.

Referring to FIG. 7 again, the condensing device further includes a water pump 34, a heat source part 32, and a liquid inlet 33, and a condensing part 01, a flow guide layer 02, a flow guide member 03, a sealing member 04, a container 05, a flow guide channel 06, a spring 11, and a water outlet 07 that are described in the foregoing embodiments.

A main difference from the embodiment shown in FIG. 9 lies in that a liquid cooling channel 13 is provided in the condensing part 01 in the embodiment, and the water pump 34 is configured to pump a coolant through the liquid cooling channel 13 to rapidly remove heat released during a condensation process, so as to maintain a low temperature of the condensing surface 09, thereby enhancing the vapor condensation rate.

A function of the heat source part 32 is the same as that in the embodiment shown in FIG. 9, and is used to heat the to-be-treated liquid in the container 05, so as to accelerate the evaporation speed and the condensation speed, thereby accelerating the treatment speed of the to-be-treated liquid. The generated condensate is also discharged to the water outlet 07 through the flow guide member 03, so as to complete evaporation treatment of the to-be-treated liquid. The liquid inlet 33 is configured to add the to-be-treated liquid to the container 05.

By using the foregoing two different cooling manners and in combination with a heating effect of the heat source part 32, a temperature in the condensation process can be effectively controlled, and the condensation efficiency and treatment speed can be improved. The air cooling manner is simple in structure and low in cost, and is applicable to cases where cooling requirements are not high. The liquid cooling manner is better in cooling effect and higher in temperature control accuracy, and is applicable to cases where the cooling requirements are high. An appropriate cooling manner is selected according to actual application requirements to better meet different usage requirements.

In addition, when the flow guide layer 02 has a relatively large area, to ensure rapid discharge of the condensate, in the foregoing implementations, at least one raised structure selected from linear, dendritic, mesh and meridian shapes may be disposed on the flow guide layer 02 for better liquid conveyance. A leaf vein structure is similar to a blade. The leaf vein generally includes a main vein, side veins, and small veins, where the main vein has a largest cross-sectional area, the quantity of the side veins is large, the side vein is relatively small in cross-sectional area, the quantity of the small veins is larger, and the small veins are comprehensively distributed. This helps to convey water and nutrition.

Based on this principle, the raised structure may imitate a blade structure, so as to effectively converge surrounding liquid into the structure, optimize a direction and a position of liquid flow in the flow guide layer, and improve a liquid conveying speed, without increasing an overall thickness of the flow guide layer.

Optionally, a plurality of drainage channels are provided for the flow guide layer 02 by using the leaf vein structure imitating the blade. The drainage channel is in contact with the flow guide layer, and one end surface of the flow guide member is connected to the drainage channel, so as to form a continuous capillary channel. A liquid directly condensed on the condensing surface 09 on which no drainage channel is provided forms a liquid film that expands circumferentially. When the liquid film reaches the drain channel, capillary force causes the liquid film to flow into the channel, thereby removing the liquid on the condensing surface 09 and reducing heat transfer heat resistance.

In actual application, a drainage channel spacing may be adjusted according to immersion performance of the condensing surface, and a thickness of the liquid film may be controlled to obtain an optimal condensation rate. A sectional thickness of the drainage channel can be selected within the range of 0.1 mm to 10 mm.

The drainage channel may be a linear, tree-shaped, mesh-shaped, or meridian-shaped structure, and may be formed by a fibrous, granular, layered, hole-shaped, or micro groove shaped capillary structure, where the hole-shaped or micro groove shaped capillary structure is disposed on a condenser, and is capillarily connected to the flow guide layer. For example, a capillary micro groove is machined from the condensing surface to an interior of the condenser, and the flow guide layer is bonded and connected to the condensing surface, and the flow guide layer is also connected to the capillary micro groove to form a capillary channel. Drainage channels of different cross-sectional thicknesses may be designed, for example, a cross-sectional thickness of the first drainage channel is greater than a cross-sectional thickness of the second drainage channel.

A connection method of the drainage channel may include at least one manner such as a nonwoven process, adhesion, gluing, hot melting, sintering, hot air bonding, and welding. By means of edge connection or superposition, the networks of each layer can be tightly combined to ensure the stability and continuity of a liquid transfer system. A specific connection process may be flexibly selected according to material characteristics and an application scenario of the flow guide layer, so as to optimize overall performance of the condensing device.

By setting the drainage channel for the flow guide layer, liquid permeability can be significantly improved, and a liquid flow speed can be accelerated. This design can reduce a local thickness of the flow guide layer, and reduce the occupation of the condensing surface, thereby improving the condensation rate. In addition, the method may further effectively increase effective areas of the condensing surface and the flow guide layer, and further optimize overall performance of the condensing device.

The terms used herein are used only for the purpose of describing specific embodiments and are not intended to limit the present disclosure. As used herein, singular forms "one", "a" and "the" are intended to include plural forms, unless the context clearly otherwise indicates. It will be further understood that the words "include" and/or "contain" when used in this specification represent the presence of the specified features, entirety, steps, operations, elements and/or components, but do not exclude the presence or add one or more other features, entirety, steps, operations, elements, components and/or groups thereof.

Although the present disclosure has been described with reference to one or more exemplary embodiments, it will be understood by those skilled in the art that various changes may be made and equivalents may be substituted for components thereof without departing from the scope of the present disclosure. In addition, many modifications may be made to adapt a particular situation or material to the teachings of the present disclosure without departing from basic scope. Therefore, the present disclosure is intended not to be limited to specific embodiments disclosed as the best mode for performing the concept of the present disclosure, but to include all embodiments falling within the scope of the claims.

### List of reference symbols

01: Condensing part
02: Flow guide layer
03: Flow guide member
04: Sealing member
05: Container
06: Flow guide channel
07: Water outlet
08: First chamber
09: Condensing surface
11: Spring
12: Heat dissipation fin
13: Liquid cooling channel
21: Liquid inlet channel
22: Overflow channel
31: Fan
32: Heat source part
33: Liquid inlet
34: Water pump
35: Thermal insulation layer
36: Overflow port
37: Liquid outlet
41: Capillary connector

## Claims

1. A condensing device, comprising a condensing part, a flow guide layer, at least one flow guide member, and a flow guide channel, wherein
the flow guide layer is disposed on a condensing surface of the condensing part, and the flow guide layer and the flow guide member are each provided with a capillary structure;
one end surface of the flow guide member is connected to the flow guide layer and placed in the flow guide channel, and the flow guide channel is configured for keeping the connection; and
condensate generated on the condensing surface and the flow guide layer is continuously discharged by means of capillary action of the flow guide layer and the flow guide member and gravity action.

2. The condensing device according to claim 1, wherein the flow guide layer comprises at least one capillary structure of a fibrous capillary structure, a granular capillary structure, a meshed capillary structure, a layered capillary structure, a hole-shaped capillary structure, a micro groove shaped capillary structure, and a sharp corner shaped capillary structure.

3. The condensing device according to claim 1, wherein the flow guide member is made of a fiber material and still maintains structural stability after water absorption.

4. The condensing device according to claim 1, wherein the condensing device further comprises a spring, and the spring is configured to ensure continuous contact between connection parts of the flow guide layer and the flow guide member.

5. The condensing device according to claim 1, wherein the condensing device further comprises a container, wherein the flow guide channel and the flow guide member are disposed at any position inside the container.

6. The condensing device according to claim 1, further comprising a capillary connector, wherein one end surface of the flow guide member is connected to the flow guide layer by the capillary connector, and the capillary connector has elasticity to accommodate variations of an interval between one end surface of the flow guide member and the flow guide layer.

7. The condensing device according to claim 1, wherein the condensing device further comprises a sealing member, and the sealing member is disposed between the condensing part and the container to form a first chamber for preventing condensate and vapor from seeping out of a gap between the condensing part and the container.

8. The condensing device according to claim 1, wherein a drainage channel is further disposed for the flow guide layer, and the drainage channel is arranged in at least one of a linear structure, a tree-shaped structure, a meshed structure, and a meridian-shaped structure.

9. The condensing device according to any one of claims 1 to 8, wherein the condensing part is of a corrugated structure or an arched structure.

10. The condensing device according to any one of claims 1 to 8, wherein heat dissipation fins are disposed on a heat dissipation surface of the condensing part, or a liquid cooling channel is disposed inside the condensing part.

11. The condensing device according to any one of claims 1 to 8, wherein the condensing device comprises a plurality of containers, the plurality of containers are successively superposed vertically, a bottom surface of each container is used as a condensing surface of an upper stage of condensing part, and a flow guide layer is disposed on both the condensing surface and the bottom of the container.

12. The condensing device according to claim 11, wherein the condensing device further comprises a liquid inlet channel and an overflow channel, and the liquid inlet channel and the overflow channel are disposed coaxially, so that when the plurality of containers are stacked, the overflow channel of an upper container is in communication with the liquid inlet channel of a lower container.

13. The condensing device according to any one of claims 1 to 8, wherein the condensing device further comprises a fan, a heat source part, and a thermal insulation layer, the fan is configured to accelerate air flow around a surface of the condensing part, the heat source part is configured to heat a liquid to be treated in a container, and the thermal insulation layer is disposed on an outer layer of the container, so as to reduce loss of heat inside the container to the outside.

14. The condensing device according to any one of claims 1 to 8, wherein the flow guide layer and/or the flow guide member are made of a highly thermally conductive material, the highly thermally conductive material comprises a metal material having a capillary structure, and the flow guide layer is of a single-layer or multi-layer structure.

15. A method for operating a condensing device, wherein the condensing device is configured according to any one of claims 1 to 14.

16. A household appliance, comprising the condensing device according to any one of claims 1 to 14.
